# EUROPEAN PATENT APPLICATION

(11) **EP 4 701 286 A1**
(43) Date of publication of application: **25.02.2026**
(21) Application number: 24807596.2
(22) Date of filing: 17.05.2024
(51) Int. Cl.: H04W 52/52, H04W 52/40, H04W 52/36, H04W 52/26

(54) **ELECTRONIC DEVICE FOR CONTROLLING TRANSMISSION POWER FOR SIGNAL AND OPERATING METHOD THEREOF**

(30) Priority: 18.05.2023 KR 20230064515; 28.06.2023 KR 20230083713
(71) Applicant: Samsung Electronics Co., Ltd., Suwon-si, Gyeonggi-do 16677 (KR)
(72) Inventor: LEE, Deokhee, Suwon-si, Gyeonggi-do 16677 (KR); YOON, Kyoungsik, Suwon-si, Gyeonggi-do 16677 (KR); JANG, Kyujae, Suwon-si, Gyeonggi-do 16677 (KR); KIM, Hojong, Suwon-si, Gyeonggi-do 16677 (KR); LEE, Sangdon, Suwon-si, Gyeonggi-do 16677 (KR); CHOI, Muyoung, Suwon-si, Gyeonggi-do 16677 (KR)
(74) Representative: Gulde & Partner
(86) International application number: PCT/KR2024/006724
(87) International publication number: WO 2024/237725

(57) **Abstract**

According to an embodiment, an electronic device comprises: a memory storing instructions; at least one communication processor; and at least one RF circuit configured to process an RF signal on the basis of a signal from the at least one communication processor. The instructions, when executed by the at least one communication processor, may cause the electronic device to: on the basis of having identified a first event, identify whether a band associated with the first event is a first band; on the basis of having identified that the band associated with the first event is the first band, identify whether a first parameter associated with transmission of an RF signal satisfies a first condition; on the basis of having identified that the first parameter satisfies the first condition, set, on the basis of a first APT table, first power as transmission power for the RF signal associated with the first event; and on the basis of having identified that the first parameter does not satisfy the first condition, change, on the basis of a second APT table, the magnitude of a baseband signal transmitted to the RF circuit so as to set second power as transmission power for the RF signal associated with the first event.

## Description

### [Technical Field]

The disclosure relates to an electronic device for controlling transmission power of a signal and a method thereof.

### [Background Art]

A wireless communication system is developing in a direction of supporting a higher data transmission rate in order to meet the continuously increasing traffic demand for wireless data. An electronic device may transmit and receive a signal having a 4G frequency, a frequency in a 5G sub6 region, and a frequency of 3 GHz to 5 GHz in order to improve a network access and data transmission rate.

Inside this electronic device, a substrate on which various electronic components are disposed to support various types of wireless mobile communication services using various frequency bands, and a connector provided for compatibility with data, and/or the like such as a communication port may be equipped. Various components (e.g., an application processor, a communication processor, or a connector) disposed in the electronic device may be disposed on a printed circuit board mainly through a surface mounted device (SMD) process.

Electronic components for a high-frequency communication and a connector for performing calibration on an RF signal path connected to the electronic components may be equipped in the printed circuit board. In a phase of assembling the electronic device, the calibration may be performed to identify whether the various electronic components for the high-frequency communication are abnormal using the connector.

### [Detailed Description of the Invention]

### [Technical Problem]

According to an embodiment, an electronic device may comprise memory storing instructions, at least one communication processor, and at least one RF circuit configured to process an RF signal based on a signal from the at least one communication processor. The instructions, when executed by the at least one communication processor, may cause the electronic device to, based on identifying a first event, identify whether a band associated with the first event is a first band. The instructions, when executed by the at least one communication processor, may cause the electronic device to, based on identifying that the band associated with the first event is the first band, identify whether a first parameter associated with transmission of an RF signal satisfies a first condition. The instructions, when executed by the at least one communication processor, may cause the electronic device to, based on identifying that the first parameter satisfies the first condition, set first power as the transmission power of the RF signal associated with the first event based on a first APT table. The instructions, when executed by the at least one communication processor, may cause the electronic device to, based on identifying that the first parameter does not satisfy the first condition, set second power as the transmission power of the RF signal associated with the first event by changing magnitude of a baseband signal transmitted to the RF circuit based on a second APT table.

In an embodiment, an operating method of an electronic device may comprise, based on identifying a first event, identifying whether a band associated with the first event is a first band. The operating method of the electronic device may comprise, based on identifying that the band associated with the first event is the first band, identifying whether a first parameter associated with transmission of an RF signal satisfies a first condition. The operating method of the electronic device may comprise, based on identifying that the first parameter satisfies the first condition, setting first power as the transmission power of the RF signal associated with the first event based on a first APT table. The operating method of the electronic device may comprise, based on identifying that the first parameter does not satisfy the first condition, setting second power as the transmission power of the RF signal associated with the first event by changing magnitude of a baseband signal transmitted to the RF circuit of the electronic device based on a second APT table.

According to an embodiment, a storage medium storing computer-readable at least one instruction may be provided, and the at least one instruction, when executed by at least one processor of an electronic device, may cause the electronic device to perform at least one operation. The at least one operation may comprise, based on identifying a first event, identifying whether a band associated with the first event is a first band. The at least one operation may comprise, based on identifying that the band associated with the first event is the first band, identifying whether a first parameter associated with transmission of an RF signal satisfies a first condition. The at least one operation may comprise, based on identifying that the first parameter satisfies the first condition, setting first power as the transmission power of the RF signal associated with the first event based on a first APT table. The at least one operation may comprise, based on identifying that the first parameter does not satisfy the first condition, setting second power as the transmission power of the RF signal associated with the first event by changing magnitude of a baseband signal transmitted to the RF circuit based on a second APT table.

A solution to a problem according to an embodiment of the disclosure is not limited to the above-described solutions, and solutions not mentioned may be clearly understood by those skilled in the art from the present specification and the accompanying drawings.

### [Brief Description of Drawings]

FIG. 1 is a block diagram illustrating an electronic device within a network environment according to an embodiment.
FIG. 2A is a block diagram illustrating an electronic device for supporting a legacy network communication and a 5G network communication according to an embodiment.
FIG. 2B is a block diagram illustrating an electronic device for supporting a legacy network communication and a 5G network communication according to an embodiment.
FIG. 3 is a block diagram illustrating an electronic device according to an embodiment.
FIG. 4 illustrates a flowchart for describing an operating method of an electronic device according to an embodiment.
FIG. 5 is a block diagram illustrating an electronic device according to an embodiment.
FIG. 6 illustrates a flowchart for describing an operating method of an electronic device according to an embodiment.
FIG. 7 illustrates a flowchart for describing an operating method of an electronic device according to an embodiment.
FIG. 8 illustrates a flowchart for describing an operating method of an electronic device according to an embodiment.
FIG. 9 illustrates a flowchart for describing an operating method of an electronic device according to an embodiment.

### [Mode for Carrying out the Invention]

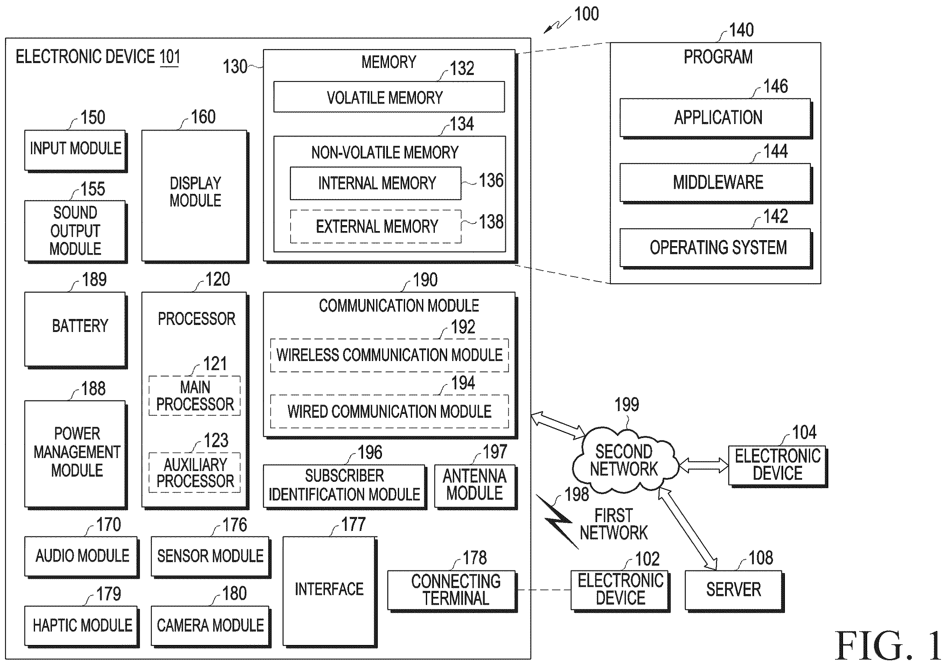

FIG. 1 is a block diagram illustrating an electronic device 101 in a network environment 100 according to an embodiment. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An AI model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The AI model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The AI model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may acquire the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless fidelity (WiFi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to some embodiments, another component (e.g., a radio frequency integrated circuit (RFIC)) other than the radiating element may be additionally formed as part of the antenna module 197.

According to an embodiment, the antenna module 197 may form a mm Wave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

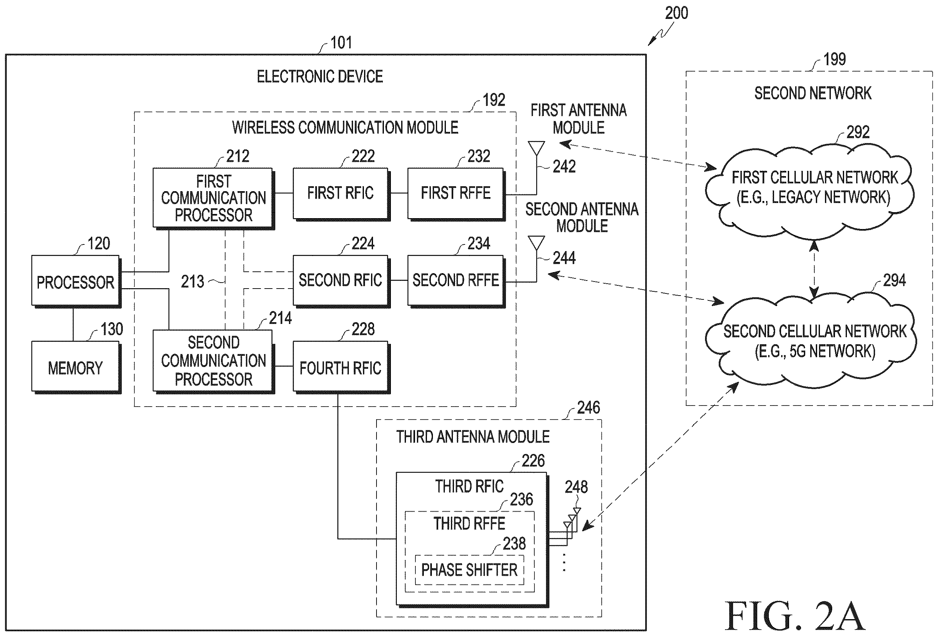

FIG. 2A is a block diagram 200 illustrating an electronic device for supporting a legacy network communication and a 5G network communication according to an embodiment. Referring to FIG. 2A, an electronic device 101 may include a first communication processor 212, a second communication processor 214, a first radio frequency integrated circuit (RFIC) 222, a second RFIC 224, a third RFIC 226, a fourth RFIC 228, a first radio frequency front end (RFFE) 232, a second RFFE 234, a first antenna module 242, a second antenna module 244, a third antenna module 244, and antennas 248. The electronic device 101 may further include a processor 120 and a memory 130. A second network 199 may include a first cellular network 292 and a second cellular network 294. According to another embodiment, the electronic device 101 may further include at least one of the components illustrated in FIG. 1, and the second network 199 may further include at least one other network. According to an embodiment, the first communication processor 212, the second communication processor 214, the first RFIC 222, the second RFIC 224, the fourth RFIC 228, the first RFFE 232, and the second RFFE 234 may form at least part of a wireless communication module 192. According to another embodiment, the fourth RFIC 228 may be omitted or included as part of the third RFIC 226.

The first communication processor 212 may establish a communication channel in a band to be used for a wireless communication with the first cellular network 292 and support a legacy network communication via the established communication channel. According to embodiments, the first cellular network 292 may be a legacy network including a 2^{nd} generation (2G), 3G, 4G, or long term evolution (LTE) network. The second communication processor 214 may establish a communication channel corresponding to a specified band (e.g., about 6GHz to about 60GHz) out of a band to be used for a wireless communication with the second cellular network 294 and support a 5G network communication via the established communication channel. According to embodiments, the second cellular network 294 may be a 5G network defined by 3GPP. Further, according to an embodiment, the first communication processor 212 or the second communication processor 214 may establish a communication channel corresponding to another specified band (e.g., about 6GHz or less) out of the band to be used for the wireless communication with the second cellular network 294 and support a 5G network communication via the established communication channel.

The first communication processor 212 may transmit and receive data to and from the second communication processor 214. For example, data supposed to be transmitted via the second cellular network 294 may be scheduled to be transmitted via the first cellular network 292. In this case, the first communication processor 212 may receive transmission data from the second communication processor 214. For example, the first communication processor 212 may transmit and receive data to and from the second communication processor 214 via an inter-processor interface 213. The inter-processor interface 213 may be implemented as, for example, a universal asynchronous receiver/transmitter (UART) (e.g., high speed-UART (HS-UART)) interface or a peripheral component interconnect bus express (PCIe) interface, but a type thereof is not limited. Alternatively, the first communication processor 212 and the second communication processor 214 may exchange control information and packet data information using, for example, a shared memory. The first communication processor 212 may transmit and receive various pieces of information such as sensing information, information about output strength, and resource block (RB) allocation information to and from the second communication processor 214.

Depending on implementation, the first communication processor 212 may not be coupled directly to the second communication processor 214. In this case, the first communication processor 212 may transmit and receive data to and from the second communication processor 214 via the processor 120 (e.g., an application processor). For example, the first communication processor 212 and the second communication processor 214 may transmit and receive data to and from the processor 120 (e.g., an application processor) via an HS-UART interface or a PCIe interface, but a type of an interface is not limited. Alternatively, the first communication processor 212 and the second communication processor 214 may exchange control information and packet data information by using, for example, the processor 120 (e.g., the application processor) and the shared memory.

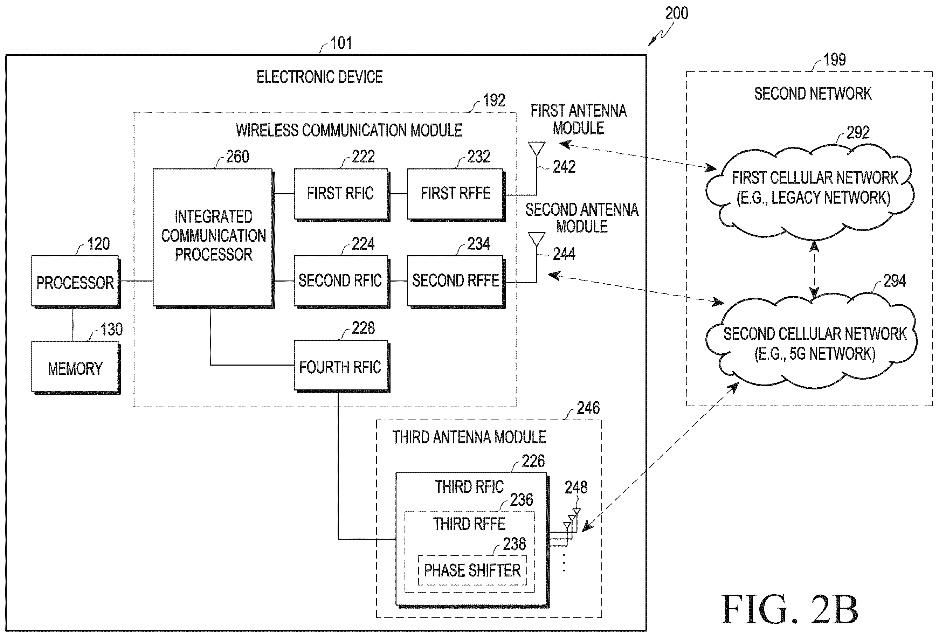

According to an embodiment, the first communication processor 212 and the second communication processor 214 may be incorporated in a single chip or a single package. According to an embodiment, the first communication processor 212 or the second communication processor 214 may be incorporated together with the processor 120, an auxiliary processor 123, or a communication module 190 in a single chip or a single package. For example, as in FIG. 2B, a communication processor 440 may support a function for communicating with both the first cellular network 292 and the second cellular network 294.

For transmission, the first RFIC 222 may convert a baseband signal generated by the first communication processor 212 to a radio frequency (RF) signal in about 700MHz to about 3GHz used in the first cellular network 292 (e.g., the legacy network). For reception, an RF signal may be obtained from the first network 292 (e.g., a legacy network) via an antenna (e.g., the first antenna module 242) and pre-processed via an RFFE (e.g., the first RFFE 232). The first RFIC 222 may convert the pre-processed RF signal to a baseband signal so that the baseband signal may be processed by the first communication processor 212.

For transmission, the second RFIC 224 may convert a baseband signal generated by the first communication processor 212 or the second communication processor 214 to an RF signal in a Sub6 band (e.g., about 6GHz or less) used in the second cellular network 294 (e.g., the 5G network). For reception, a 5G Sub6 RF signal may be obtained from the second cellular network 294 (e.g., the 5G network) via an antenna (e.g., the second antenna module 244) and pre-processed in an RFFE (e.g., the second RFFE 234). The second RFIC 224 may convert the pre-processed 5G Sub6 RF signal to a baseband signal so that the baseband signal may be processed by a corresponding one between the first communication processor 212 and the second communication processor 214.

For transmission, the third RFIC 226 may convert a baseband signal generated by the second communication processor 214 to an RF signal (hereinafter, referred to as, a 5G Above6 RF signal) in a 5G Above6 band (e.g., about 6GHz to about 60GHz) to be used in the second cellular network 294 (e.g., the 5G network). For reception, a 5G Above6 RF signal may be obtained from the second cellular network 294 (e.g., the 5G network) via an antenna (e.g., the antenna 248) and pre-processed via the third RFFE 236. The third RFIC 226 may convert the pre-processed 5G Above6 RF signal to a baseband signal so that the baseband signal may be processed by the second communication processor 214. According to an embodiment, the third RFFE 236 may be formed as part of the third RFIC 226.

According to an embodiment, the electronic device 101 may include the fourth RFIC 228 separately from or as part of the third RFIC 226. In this case, the fourth RFIC 228 may convert a baseband signal generated by the second communication processor 214 to an RF signal in an intermediate frequency band (e.g., about 9GHz to about 11GHz) (hereinafter, referred to as an IF signal), and provide the IF signal to the third RFIC 226. The third RFIC 226 may convert the IF signal to a 5G Above6 RF signal. During reception, a 5G Above6 RF signal may be received from the second cellular network 294 (e.g., the 5G network) via an antenna (e.g., the antenna 248) and converted to an IF signal by the third RFIC 226. The fourth RFIC 228 may convert the IF signal to a baseband signal so that the baseband signal may be processed by the second communication processor 214.

According to an embodiment, the first RFIC 222 and the second RFIC 224 may be implemented as at least part of a single chip or a single package. According to an embodiment, if the first RFIC 222 and the second RFIC 224 are implemented as a single chip or a single package in FIG. 2A or 2B, the first RFIC 222 and the second RFIC 224 may be implemented as an integrated RFIC. In this case, the integrated RFIC is connected to the first RFFE 232 and the second RFFE 234, so the integrated RFIC may convert a baseband signal into a signal of a band supported by the first RFFE 232 and/or the second RFFE 234, and transfer the converted signal to one of the first RFFE 232 and the second RFFE 234. According to an embodiment, the first RFFE 232 and the second RFFE 234 may be implemented as at least part of a single chip or a single package. According to an embodiment, at least one of the first antenna module 242 or the second antenna module 244 may be omitted or combined with the other antenna module to process RF signals in a plurality of corresponding bands.

According to an embodiment, the third RFIC 226 and the antenna 248 may be arranged on the same substrate to form a third antenna module 246. For example, the wireless communication module 192 or the processor 120 may be arranged on a first substrate (e.g., a main PCB). In this case, the third RFIC 226 may be arranged in a partial area (e.g., the bottom surface) of a second substrate (e.g., a sub PCB) other than the first substrate and the antenna 248 may be arranged in another partial area (e.g., the top surface) of the second substrate, to form the third antenna module 246. As the third RFIC 226 and the antenna 248 are arranged on the same substrate, it is possible to reduce length of a transmission line between the third RFIC 226 and the antenna 248. This may reduce, for example, amount of loss (e.g., attenuation) of a high frequency band (e.g., about 6GHz to about 60GHz) signal used for a 5G network communication due to the transmission line may be reduced. Therefore, the electronic device 101 may increase quality or a speed of a communication with the second cellular network 294 (e.g., the 5G network).

According to an embodiment, the antenna 248 may be formed as an antenna array including a plurality of antenna elements which may be used for beamforming. In this case, the third RFIC 226 may include a plurality of phase shifters 238 corresponding to the plurality of antenna elements, for example, as part of the third RFFE 236. During transmission, each of the plurality of phase shifters 238 may change a phase of a 5G Above6 RF signal to be transmitted to the outside of the electronic device 101 (e.g., a base station in the 5G network) via a corresponding antenna element. During reception, each of the phase shifters 238 may change a phase of a 5G Above6 RF signal received from the outside via a corresponding antenna element to the same or substantially same phase. This enables transmission or reception via beamforming between the electronic device 101 and the outside.

The second cellular network 294 (e.g., the 5G network) may be operated independently of (e.g., Stand-Alone (SA)) or may be connected to and operated with (e.g., Non-Stand alone (NSA)) the first cellular network 292 (e.g., the legacy network). For example, in the 5G network, only an access network (e.g., a 5G radio access network (RAN) or next generation RAN (NG RAN)) may exist, and a core network (e.g., a next generation core (NGC)) may not exist. In this case, after accessing the access network of the 5G network, the electronic device 101 may access an external network (e.g., an Internet) under the control of a core network (e.g., an evolved packed core (EPC)) of the legacy network. Protocol information for a communication with the legacy network (e.g., LTE protocol information) and protocol information for a communication with the 5G network (e.g., New Radio (NR) protocol information) may be stored in the memory 230 and accessed by another component (e.g., the processor 120, the first communication processor 212, or the second communication processor 214).

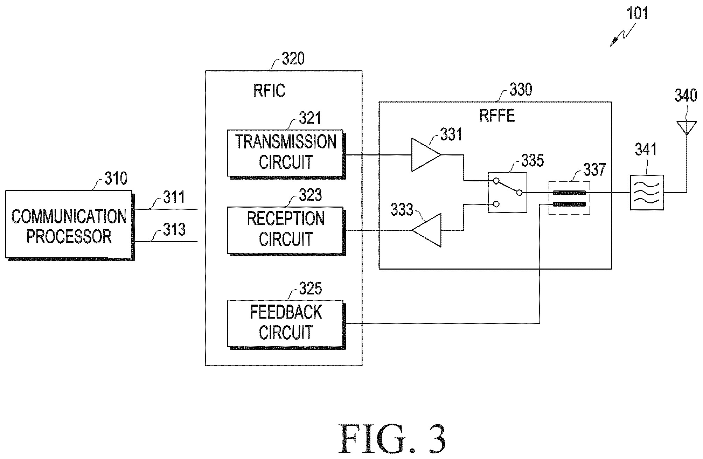

FIG. 3 is a block diagram illustrating an electronic device according to an embodiment.

According to an embodiment of the disclosure, an electronic device 101 may be configured to include an antenna module 340, an RFFE 330 electrically connected to the antenna module 340, an RFIC 320 electrically connected to the RFFE 330, and a communication processor 310 operably connected to the RFIC 320. In an embodiment of the disclosure, an RF component including at least one of the RFIC 320, the RFFE 330, or the antenna module 340 may be referred to as an "RF circuit." In an embodiment, in FIG. 3, the electronic device 101 is illustrated as including, but not limited to, the communication processor 310, the RFIC 320, the RFFE 330, and/or the antenna module 340. For example, the electronic device 101 may further include at least one component illustrated in FIG. 1.

In an embodiment, the antenna module 340 may be included in at least one of an antenna module 197 in FIG. 1, a first antenna module 242, a second antenna module 244, or a third antenna module 246 in FIG. 2A. For convenience of a description, one antenna module 340 is illustrated in FIG. 3, and the electronic device 101 may include one or more antenna modules. The antenna module 340 may emit an RF signal and/or receive an RF signal from the outside.

In an embodiment, the RFFE 330 may be included in at least one of the first RFFE 232, the second RFFE 234, or the third RFFE 236 in FIG. 2A. For convenience of a description, one RFFE 330 is illustrated in FIG. 3, and the electronic device 101 may include one or more RFFEs. The RFFE 330 may be configured to include at least one power amplifier (PA) 331, at least one low noise amplifier (LNA) 333, an SPDT switch 335 electrically connected to the PA 331 and the LNA 333, and a coupler 337 electrically connected to the SPDT switch 335. The PA 331 may amplify an RF signal outputted by a transmission circuit 321 of the RFIC 320. The RF signal amplified by the PA 331 may pass through a filter 341 through the SPDT switch 335 and the coupler 337. The LNA 333 may amplify the RF signal which has been received by the antenna module 340 and has passed through the filter 341 and the SPDT switch 335. The RF signal amplified by the LNA 333 may be transferred to a reception circuit 323 of the RFIC 320. In an embodiment, when the RF signal amplified by the PA 331 passes through the coupler 337, a feedback signal may be generated. The feedback signal generated by the coupler 337 may be transferred to a feedback circuit 325 of the RFIC 320. The communication processor 310 and/or the RFIC 320 may identify transmission power of the RF signal based on the feedback signal. The communication processor 310 may increase or decrease the transmission power of the RF signal emitted by the antenna module 340 based on identifying that the identified transmission power is different from target power. In an embodiment, the at least one RF component included in the RFFE 330 illustrated in FIG. 3 is exemplary, and according to an embodiment of the disclosure, the RFFE 330 may include a component different from the component illustrated in FIG. 3. For example, the RFFE 330 may further include a diplexer (not illustrated) and/or a duplexer (not illustrated).

In an embodiment, the RFIC 320 may be included in at least one of the first RFIC 222, the second RFIC 224, the third RFIC 226, or a fourth RFIC 228 in FIG. 2A. For convenience of a description, one RFIC 320 is illustrated in FIG. 3, and the electronic device 101 may include one or more RFICs. The RFIC 320 may be configured to include the transmission circuit 321, the reception circuit 323, and/or the feedback circuit 325. For example, the RFIC 320 may be electrically connected to the communication processor 310 through a data signal line 311 and a control signal line 313. The RFIC 320 may transmit and receive data to and from the communication processor 310 through the data signal line 311. The RFIC 320 may receive a control signal from the communication processor 310 through the control signal line 313. For example, the RFIC 320 may receive a control signal for controlling at least one of the transmission circuit 321, the reception circuit 323, or the feedback circuit 325 from the communication processor 310 through the control signal line 313. The transmission circuit 321 may generate an RF signal based on receiving a digital signal from the communication processor 310. The transmission circuit 321 may, for example, include a digital-to-analog converter (DAC)(not illustrated) for converting the digital signal outputted by the communication processor 310 into an analog signal, a mixer (not illustrated) for mixing the converted analog and a signal outputted by an oscillator (not illustrated), and/or a PA driver (not illustrated) for amplifying a mixed RF signal. In an embodiment, the RFIC 320 may include one or more transmission circuits. The reception circuit 323 may convert an RF signal which has been received through the antenna module 340 and amplified by the RFFE 330 into a digital signal for transferring to the communication processor 310. The feedback circuit 325 may obtain a signal for detecting the transmission power of the RF signal emitted through the antenna module 340 based on a signal transferred through the coupler 337.

In an embodiment, the communication processor 310 may be included in at least one of a processor 120 in FIG. 1, a first communication processor 212 and a second communication processor 214 in FIG. 2A, or an integrated communication processor 260 in FIG. 2B. In an embodiment, the communication processor 310 may control the overall operation for changing magnitude of the transmission power of the RF signal emitted through the antenna module 340. In an embodiment, the communication processor 310 may control the transmission power of the RF signal emitted through the antenna module 340 based on controlling magnitude of a digital gain for outputting a digital signal and/or an analog gain corresponding to an RF component included in an RF circuit (e.g., the RFIC 320 and/or the RFFE 330). In an embodiment, based on controlling the magnitude of the digital gain and/or the analog gain, the communication processor 310 may decrease the transmission power of the RF signal through the antenna module 340. In an embodiment, an operation in which the electronic device 101 (or the communication processor 310) decreases the transmission power of the RF signal may be referred to as a "power back-off" operation, and there is no limitation on the term. The operation performed by the communication processor 310 to control the transmission power of the RF signal will be described later.

In an embodiment, the electronic device 101 may further include a filter 341 located between the RFFE 330 and the antenna module 340. For convenience of a description, one filter 341 is illustrated in FIG. 3, and it will be understood by those skilled in the art that the electronic device 101 may include one or more filters corresponding to each of one or more bands. In an embodiment, the filter 341 may be a band-pass filter (BPF) for filtering a signal in a frequency domain excluding a specific band from the RF signal outputted by the RFFE 330. In an embodiment, an unwanted signal (or a spurious) included in the RF signal outputted by the RFFE 330 may be removed through the filter 341.

In an embodiment, at least one RF component included in the RFIC 320 and/or the RFFE 330 may generate spurious emission at a frequency away from a target frequency band upon transmission of the RF signal due to a non-linear characteristic. For example, the mixer included in the transmission circuit 321 may generate a spurious due to a sum or difference of harmonic components in addition to a frequency component corresponding to a sum or difference of input frequencies. In an embodiment, the spurious generated by the mixer may be amplified after passing through the PA driver included in the transmission circuit 321 and the PA 331 included in the RFFE 330. In an embodiment, an RF signal modulated by an orthogonal frequency division multiplexing (OFDM) scheme may exhibit a relatively high peak-to-average power ratio (PAPR). The PA 331 included in the RFFE 330 may generate inter-modulation distortion (IMD), which is a non-linear component, by amplifying the modulated RF signal. The filter 341 may remove the amplified spurious and the IMD. In an embodiment, among the amplified spurious and the IMD, an edge frequency component of a band corresponding to the filter 341 may pass through the filter 341 and be emitted into the air through the antenna module 340. In an embodiment, the spurious emitted through the antenna module 340 may cause interference in a wireless communication channel of another electronic device in communication with a network (or a base station) based on the band corresponding to the filter 341. In an embodiment, the electronic device 101 may control at least one RF component so that the RF signal emitted through the antenna module 340 may satisfy a 3GPP standard for decreasing the interference in the wireless communication channel of the other electronic device. The electronic device 101 may relatively decrease magnitude of the spurious to a level satisfying the standard based on controlling the at least one RF component to operate in a linear region. The electronic device 101 may improve a band-edge performance based on decreasing the magnitude of the spurious.

In an embodiment, the electronic device 101 may decrease the relative magnitude of the spurious based on adjusting bias voltage and/or bias current supplied to the PA 331. For example, the electronic device 101 may obtain bias voltage (e.g., "PA Bias") and bias current (e.g., "PA ICQ") corresponding to each target power based on performing a power sweep in an RF calibration process. The electronic device 101 may store each bias voltage and bias current corresponding to target power within a power sweep range in memory (e.g., memory 130). The electronic device 101 may adjust bias current supplied to the PA 331 based on identifying bias voltage and/or bias current corresponding to the target power upon transmission of the RF signal. In an embodiment, a power modulator (not illustrated) may operate in an average power tracking (APT) mode to supply the bias current to the PA 331. The electronic device 101 may control the PA 331 to operate linearly based on increasing bias and/or ICQ supplied to the PA 331.

In an embodiment, the electronic device 101 may control the PA 331 to operate in the linear region based on limiting maximum transmission power of the electronic device 101. In an embodiment, based on limiting the maximum transmission power, the electronic device 101 may decrease amount of current consumed upon a Tx operation (e.g., an operation of providing a voice call service) compared to a PA biasing scheme. The electronic device 101 may maintain linearity of the PA 331 based on adjusting the bias current supplied to the PA 331 in consideration of a back-off margin of the PA 331. The electronic device 101 may improve the band-edge performance based on maintaining the PA 331 not to operate in the non-linear region.

In an embodiment, the electronic device 101 may decrease the magnitude of the spurious emitted by the antenna module 340 based on decreasing the digital gain of the communication processor 310. In an embodiment, a spurious included in the digital signal outputted by the communication processor 310 may have a relatively greater influence on magnitude of a spurious emitted into the air than the spurious generated by the RFIC 320 and/or the RFFE 330. For example, the spurious included in the digital signal may have a dominant influence on the spurious amplified by the RFIC 320 and the RFFE 330 and emitted through the antenna module 340. The electronic device 101 may relatively decrease magnitude of total spurious emitted through the antenna module 340 based on decreasing the digital gain of the communication processor 310. For example, the communication processor 310 may decrease magnitude of a baseband signal transmitted to the RFIC 320 through the data signal line 311 based on decreasing the digital gain. The communication processor 310 may increase magnitude of the analog gain of the RFIC 320 based on transmitting a control signal to the RFIC 320 through the control signal line 313. The communication processor 310 may amplify a baseband signal whose magnitude is decreased based on increasing the magnitude of the analog gain of the RFIC 320. For example, the communication processor 310 may increase an RF gain index (RGI) value corresponding to the PA driver of the transmission circuit 321. The communication processor 310 may compensate for the transmission power of the RF signal emitted into the air through the antenna module 340 based on decreasing the magnitude of the digital gain and increasing the magnitude of the analog gain. Based on compensating for the transmission power of the RF signal by increasing the magnitude of the analog gain, the electronic device 101 may transmit, to the communication network, an RF signal whose magnitude of the spurious is decreased without decreasing uplink coverage, in contrast to a scheme of limiting maximum transmission power of the electronic device 101. The electronic device 101 may transmit an RF signal which satisfies maximum power reduction (MPR) defined according to the 3GPP standard through the antenna module 340 based on compensating for the transmission power of the RF signal. In an embodiment, an operation in which the electronic device 101 (or the communication processor 310) decreases the magnitude of the spurious emitted through the antenna module 340 based on decreasing the magnitude of the digital gain and increasing the magnitude of the analog gain may be referred to as a "Txfront end (TxFE) backoff mode operation."

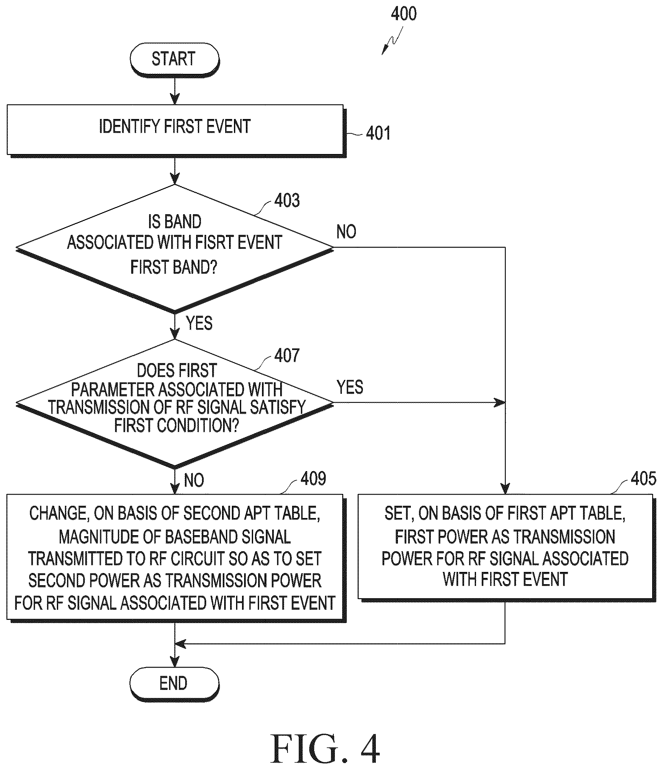

FIG. 4 illustrates a flowchart 400 for describing an operating method of an electronic device according to an embodiment.

According to an embodiment, an electronic device 101 (e.g., at least one of a processor 120, a first communication processor 212, a second communication processor 214, an integrated communication processor 260, or a communication processor 310) may identify a first event in operation 401. In an embodiment, the electronic device 101 may identify a voice call event or a handover event. In an embodiment, the electronic device 101 may perform a cell search based on scanning one or more bands. The electronic device 101 may select a cell capable of communicating with the electronic device 101 based on performing the cell search. For example, the electronic device 101 may perform a cell selection based on receiving, from an LTE communication network, a synchronization signal having a received signal strength indication (RSSI) of a level capable of being decoded.

In an embodiment, the electronic device 101 may identify whether a band associated with the first event is a first band in operation 403, based on identifying the first event. The electronic device 101 may identify whether a band corresponding to a selected cell is the first band whose backoff margin is relatively small. The first band may be, for example, a B30 band of about 2310 MHz or a B48 band of about 3600 MHz, and the first band is not limited to the above-described example. The electronic device 101 may identify an APT table to be referred to for setting transmission power of an RF signal among a first APT table or a second APT table based on identifying whether the band associated with the first event is the first band.

In an embodiment, the electronic device 101 may store an APT table corresponding to B30 based on performing a power sweep in an RF calibration process. A power sweep condition in the RF calibration process may be set on the premise that a specific number of RBs are allocated. In an embodiment, the transmission power of the RF signal corresponding to B30 may be set based on the APT table stored in the RF calibration process as shown in Table 1 below. An APT table according to Table 1 may be referred to as a "first APT table" or a "default APT table."

**[Table 1]**

| TxAGC | AptVcc | AptPower | APT FBRx Gain State | APT FBRx HW Gain | APT RGI Delta Power |
|---|---|---|---|---|---|
| 51 | 4500 | 25.6 | 5 | 405 | 0 |
| 50 | 4500 | 25.2 | 5 | 390 | -0.4 |
| 49 | 4500 | 25 | 5 | 380 | -0.2 |
| 48 | 4500 | 24.8 | 5 | 370 | -0.2 |
| 47 | 4500 | 24.5 | 5 | 360 | -0.3 |
| 46 | 4500 | 24.2 | 5 | 344 | -0.3 |
| ... | ... | ... | ... | ... | ... |
| 35 | 1800 | 14.1 | ... | ... | ... |
| 34 | 1562 | 12.7 | ... | ... | ... |
| 33 | 1450 | 11.9 | ... | ... | ... |
| ... | ... | ... | ... | ... | ... |

In an embodiment, referring to the APT table in Table 1, the electronic device 101 may be configured to transmit an RF signal having a power of about 25.6 dBm based on controlling magnitude of a hardware gain. In an embodiment, the transmission power of about 25.6 dBm corresponding to an RGI value of 51 may indicate magnitude of power identified at an antenna module terminal. For example, if magnitude of front-end loss due to hardware is about 4 dBm, power magnitude of an RF signal corresponding to a B30 band outputted by a PA may be set to about 29.6 dBm for a transmission power of about 25.6 dBm. In an embodiment, if the RGI value is 52, since output power of the PA exceeds about 29.6 dBm, a maximum RGI value on the APT table may be limited to 51 in consideration of that damage of the hardware (e.g., a diplexer, a duplexer, a switch, and/or a PA) may occur. In an embodiment, in an online state of a network communication associated with the B30 band, a parameter associated with an uplink signal may be set differently from the RF calibration process. For example, the electronic device 101 may report strength of a synchronization signal to a base station which manages the cell selected in operation 401. The electronic device 101 may receive information associated with a bandwidth, a modulation scheme, or the number of RBs from the base station in response to the report. In an embodiment, if a parameter associated with a uplink signal is set differently from the setting of the RF calibration process, the electronic device 101 may transmit an RF signal having power smaller than the target power due to a lack of RGI room. In an embodiment, the RGI room may be a value obtained by subtracting a maximum RGI value by a power sweep (or an APT sweep) from an RGI value for outputting maximum power. For example, referring to Table 1, a maximum RGI value on the APT table for the B30 band may be 51. Referring to Table 1, an RGI value for outputting AptPower having a value of 25 may be 49. RGI room for the B30 band may be a 2 obtained by subtracting 51 from 49. In an embodiment, if the RGI room is insufficient, in a TxFE backoff mode, an RF signal having a transmission power smaller than the maximum transmission power according to the APT table may be outputted through an antenna module (e.g., an antenna module 340). In an embodiment, in an online call scenario of B30, the maximum transmission power of the RF signal outputted through the antenna module may be about 23.0 dBm as in Table 2 below.

**[Table 2]**

| SlotPowerRequested (dB10) | CombinedPower (dB10) | RgiVal |
|---|---|---|
| 230 | 230 | 49 |

In an embodiment, referring to Table 2, SlotPowerRequest may represent transmission power of an RF signal required by a network (or a base station). CombinedPower may be a measurement value of transmission power of an RF signal outputted from the antenna module terminal. In an embodiment, upon a B30-based transmission operation, the electronic device 101 may relatively decrease a spurious outputted through the antenna module based on operating in the TxFE backoff mode. In an embodiment, if the electronic device 101 operates in the TxFE backoff mode, the electronic device 101 may decrease magnitude of a spurious inputted to an RFIC (e.g., an RFIC 320) based on backoff of a digital gain by about 3 dB. In an embodiment, in order to output target power of about 23 dB, the electronic device 101 may be required to increase an RGI value corresponding to an analog gain by 3 codes. Referring to Table 1, since the maximum RGI value on the APT table is set to 51, the electronic device 101 may increase the RGI value by 2 codes and output an RF signal having maximum transmission power of about 22.0 dBm, which is about 1 dB lower than the target power, based on the RGI value of 51. In an embodiment, if the electronic device 101 operates in the TxFE backoff mode based on the APT table in Table 1, an RF signal having power not satisfying maximum transmission power according to an allowable standard of federal communications commission (FCC) may be outputted by the electronic device 101. In an embodiment, upper limit of the maximum transmission power according to the allowable standard of FCC may be +1 dB compared to the target power. Lower limit of the maximum transmission power according to the allowable standard of FCC may be -1.5 dB compared to the target power. In an embodiment, if the electronic device 101 operates in the TxFE backoff mode based on the APT table in Table 1, a UL coverage of the electronic device may also be decreased. In an embodiment, the electronic device 101 may set transmission power of an RF signal based on the second APT table so that maximum transmission power of an RF signal corresponding to the first band with relatively small RGI room meets an FCC standard upon transmission. In an embodiment, based on identifying that the band associated with the first event is not the first band (Operation 403 - No), the electronic device 101 may set first power as transmission power of an RF signal associated with the first event based on the first APT table in operation 405. The electronic device 101 may set power according to the first APT table stored in the RF calibration process as the transmission power of the RF signal associated with the first event based on identifying that the band associated with the first event is a second band with relatively large transmission power room. In an embodiment, based on identifying that the band associated with the first event is the first band (Operation 403 - Yes), the electronic device 101 may identify whether a first parameter associated with transmission of the RF signal satisfies a first condition in operation 407. In an embodiment, the first condition may include that the first parameter matches at least one of a bandwidth, a modulation scheme, or the number of RBs set in association with a network communication which is based on an edge frequency of the first band. For example, a condition for ensuring a performance of the network communication based on the edge frequency of the first band may be set. The electronic device 101 may identify whether the first parameter including information associated with the at least one of the bandwidth, the modulation scheme, or the number of RBs received from the network meets the condition. For example, the first condition may be a case in which a partial RB is allocated in a 10 MHz bandwidth and a modulation scheme is 16-QAM.

In an embodiment, based on identifying that the first parameter associated with the transmission of the RF signal does not satisfy the first condition (Operation 407-No), the electronic device 101 may set second power as the transmission power of the RF signal associated with the first event by changing magnitude of a baseband signal transferred to an RF circuit based on the second APT table in operation 409. In an embodiment, based on identifying the first parameter, the electronic device 101 may identify that full RB is allocated in the 10 MHz bandwidth and the modulation scheme is QPSK. The electronic device 101 may operate in the TxFE backoff mode based on identifying that the first parameter does not satisfy the first condition. The electronic device 101 may set transmission power of an RF signal corresponding to B30 based on the second APT table additionally stored in the RF calibration process as in Table 3 below in order to secure the band-edge performance. In an embodiment, the second APT table may be referred to as a "TxFE backoff mode APT table."

**[Table 3]**

| TxAGC | AptVcc | AptPower |
|---|---|---|
| 53 | 4500 | 25.6 |
| 52 | 4500 | 25.2 |
| 51 | 4500 | 25 |
| ... | ... | ... |
| ... | ... | ... |
| 35 | 1792 | 11.9 |
| 34 | 1600 | 10.7 |
| 33 | 1509 | 9.6 |
| ... | ... | ... |

In an embodiment, referring to Table 3, RF calibration may be performed in a state in which TxFE backoff of 2 dB is applied. If the RF calibration is performed in the state in which the TxFE backoff is applied, input power of the RFIC (e.g., the RFIC 320) decreases, so the power sweep may be performed based on a larger RGI value (e.g., an RGI value which is about 2 codes higher than a maximum RGI value in a state in which the TxFE backoff is not applied). If the RF calibration is performed in the state in which the TxFE backoff is applied, even though a power sweep is performed based on a larger RGI value, power corresponding to a maximum RGI value on a table may not exceed maximum power (max power) in consideration of prevention of damage to a PA. In an embodiment, referring to Table 3, the electronic device 101 may refer to an RGI value up to code 53 upon setting transmission power, may satisfy the FCC standard without occurrence of a power drop, and may also prevent a decrease in the UL coverage. In an embodiment, if the electronic device 101 sets the transmission power of the RF signal based on the second APT table, a power drop occurring in the antenna module (e.g., the antenna module 340) may not occur. In an embodiment, in an initial access procedure corresponding to an event of any one of a voice call service, a band handover, or a channel handover, the electronic device 101 may identify the power drop of the antenna module. For example, the communication processor (e.g., the communication processor 310) may identify that a feedback reception error (FBRx error) has occurred based on identifying a feedback reception (FBRx) signal transferred to a feedback circuit (e.g., a feedback circuit 325). For example, the communication processor 310 may identify that the power drop of about 1.7 dB has occurred at the antenna module 340 terminal based on identifying that an error code (ft_err code) included in the feedback reception signal is 17. In an embodiment, the power drop may occur due to sequentially changing the digital gain and the analog gain upon the TxFE backoff mode operation. For example, the communication processor 310 may backoff the digital gain with a value set based on the first APT table. Power of an RF signal outputted by the RFIC (e.g., the RFIC 320) may be dropped by amount of the backoff of the digital gain. Power of an RF signal amplified by an RFFE (e.g., an RFFE 330) may be dropped due to the backoff of the digital gain. The communication processor 310 may identify that the FBRx error occurs in proportion to the amount of the backoff of the digital gain based on the feedback reception signal transferred to the RFIC 320 through a coupler (e.g., a coupler 337). The communication processor 310 may compensate for the FBRx error based on increasing an analog gain of the RFIC 320. For example, the communication processor 310 may increase a value of the RGI code. If the FBRx error occurs, when a random access channel (RACH) operation between the electronic device 101 and a base station is performed, RACH failure or retry may be repeated.

The electronic device 101 according to an embodiment may change the magnitude of the digital gain and the analog gain at the same time based on the second APT table additionally stored in the RF calibration process. The electronic device 101 may relatively decrease the risk of the FBRx error due to the power drop of the antenna module based on decreasing the digital gain and increasing the analog gain at the same time.

In an embodiment, based on identifying that the first parameter associated with the transmission of the RF signal satisfies the first condition (Operation 407-Yes), the electronic device 101 may set the first power as the transmission power of the RF signal associated with the first event based on the first APT table in operation 405.

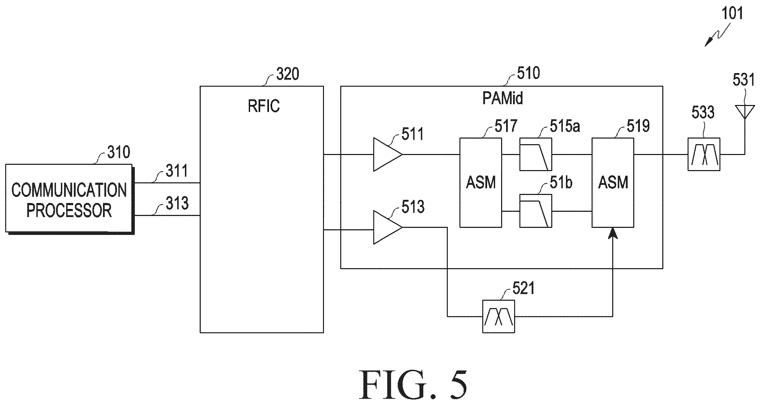

FIG. 5 is a block diagram illustrating an electronic device according to an embodiment.

In an embodiment, a first RFFE (e.g., a first RFFE 330) may be designed to process an LTE signal (e.g., an RF signal corresponding to a B30 band) of a middle band (MB) and a high band (HB). Since an RF component has been described in detail with reference to FIG. 3, a description of a configuration overlapping with that of FIG. 3 may not be repeated in FIG. 5. Referring to FIG. 5, for example, the first RFFE 330 may be implemented in a form of a power amplitude module including duplexer (PAMid) 510. In an embodiment, the PAMid 510 may include a first PA 511 and a second PA 513. In an embodiment, the first PA 511 may amplify an RF signal corresponding to a second band. For example, the first PA 511 may amplify an RF signal associated with a GSM network. An RF signal amplified by the first PA 511 may be transferred to a first antenna module 531 by passing through a first antenna switching module (ASM) 517, any one of one or more low-pass filters (LPFs) 515a, 515b, and a first duplexer 533. The RF signal corresponding to the second band may be emitted by the first antenna module 531. In an embodiment, the second PA 513 may amplify an RF signal corresponding to a first band. The RF signal amplified by the second PA 513 may pass through a second duplexer 521, a second ASM 519, and the first duplexer 533 to be transferred to the first antenna module 531. The RF signal corresponding to the first band amplified by the second PA 513 may be emitted into the air through the first antenna module 531. For example, the first band may be the B30 band, and the first band is not limited to examples described above. The duplexer 521 corresponding to the B30 band may be disposed outside the PAMid 510. For example, the duplexer 521 corresponding to the B30 band may be disposed on a main PCB of an electronic device 101. In an embodiment, if the duplexer 521 is disposed outside the PAMid 510, an insertion loss (IL) may increase and a front end (FE) loss of the RF signal corresponding to the B30 band may increase. For example, since the FE loss of the RF signal increases due to an SPDT switch (not illustrated) and PCB wiring (not illustrated) which are additionally required in a process of disposing the duplexer 521, transmission power room of the RF signal corresponding to the B30 band which the electronic device 101 may output may decrease. For example, the electronic device 101 may increase an analog gain of a PA (or an RGI value corresponding to the PA) in order to output an RF signal of the same target power. If the electronic device 101 excessively increases the analog gain of the PA, a band-edge performance may deteriorate due to a spurious described above. If the electronic device 101 operates in a TxFE backoff mode for a decrease in a spurious, a case may occur that which an RF signal satisfying the target power may not be output.

In an embodiment, the electronic device 101 may set transmission power of the RF signal corresponding to the first band based on a second APT table to secure the band-edge performance based on operation 409 in FIG. 4. For example, the electronic device 101 may decrease a digital gain of the communication processor 310 and increase an analog gain of the RFIC 320 based on the second APT table at the same time. The electronic device 101 may emit the RF signal satisfying the target power through the second antenna module 533 according to maximum transmission power of the RF signal corresponding to the B30 band set based on the second APT table.

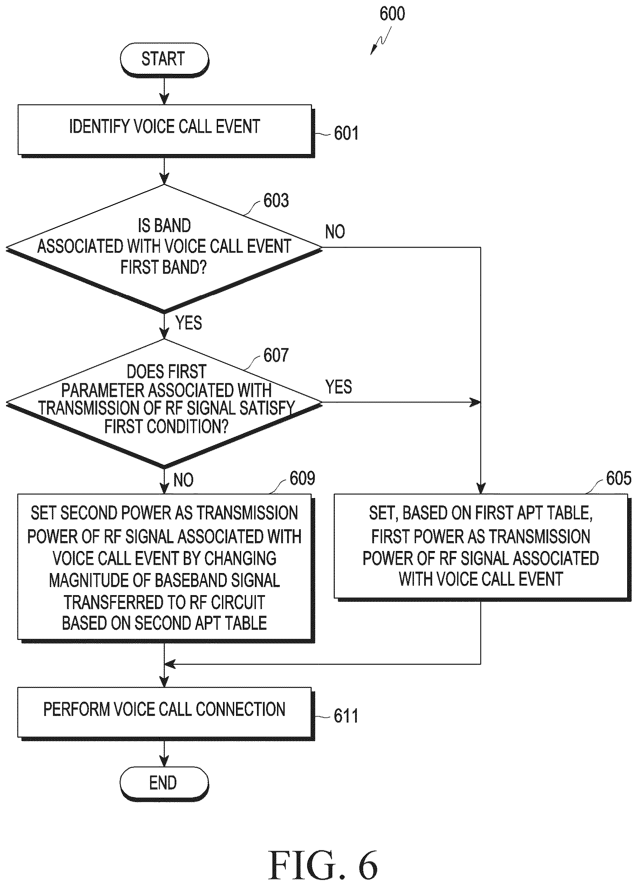

FIG. 6 illustrates a flowchart 600 for describing an operating method of an electronic device according to an embodiment. For an operating method of an electronic device 101, a description overlapping with that of FIG. 4 may not be repeated in FIG. 6.

According to an embodiment, an electronic device 101 (e.g., at least one of a processor 120, a first communication processor 212, a second communication processor 214, an integrated communication processor 260, or a communication processor 310) may identify a voice call event in operation 601. In an embodiment, the electronic device 101 may select a cell capable of communicating with the electronic device 101 based on performing a cell search. For example, the electronic device 101 may perform cell selection based on receiving, from an LTE communication network, a synchronization signal having an RSSI of a level capable of being decoded.

In an embodiment, based on identifying the voice call event, the electronic device 101 may identify whether a band associated with the voice call event is a first band in operation 603. The electronic device 101 may identify whether a band corresponding to a selected cell is the first band whose backoff margin is relatively small. The first band may be, for example, a B30 band or a B48 band, and the first band is not limited to an example described above. The electronic device 101 may identify an APT table to be referred to for setting transmission power of an RF signal among a first APT table and a second APT table, based on identifying whether the band associated with the voice call event is the first band.

In an embodiment, based on identifying that the band associated with the voice call event is not the first band (Operation 603 - No), the electronic device 101 may set first power as the transmission power of the RF signal associated with the voice call event based on the first APT table in operation 605. The electronic device 101 may set power according to the first APT table stored in an RF calibration process as the transmission power of the RF signal associated with the voice call event, for example, based on identifying that the band associated with the voice call event is a second band whose transmission power room is relatively large.

In an embodiment, based on identifying that the band associated with the voice call event is the first band (Operation 603 - Yes), the electronic device 101 may identify whether a first parameter associated with transmission of the RF signal satisfies a first condition in operation 607. In an embodiment, the first condition may include that the first parameter matches at least one of a bandwidth, a modulation scheme, or a number of RBs set in association with a network communication which is based on an edge frequency of the first band. For example, the first condition may be a case where a partial RB is allocated in a 10 MHz bandwidth and the modulation scheme is 16-QAM.

In an embodiment, based on identifying that the first parameter associated with the transmission of the RF signal does not satisfy the first condition (Operation 607 - No), the electronic device 101 may set second power as the transmission power of the RF signal associated with the voice call event by changing magnitude of a baseband signal transferred to an RF circuit based on the second APT table in operation 609. In an embodiment, based on identifying the first parameter, the electronic device 101 may identify that a full RB is allocated in the 10 MHz bandwidth, and the modulation scheme is QPSK. The electronic device 101 may operate in a TxFE backoff mode based on identifying that the first parameter does not satisfy the first condition. The electronic device 101 may set transmission power of an RF signal corresponding to B30 based on the second APT table additionally stored in an RF calibration process to secure a band-edge performance.

In an embodiment, based on identifying that the first parameter associated with the transmission of the RF signal satisfies the first condition (Operation 607 - Yes), the electronic device 101 may set the first power as the transmission power of the RF signal associated with the voice call event, based on the first APT table, in operation 605. In an embodiment, based on identifying the first parameter, the electronic device 101 may identify that the partial RB is allocated in the 10 MHz bandwidth and the modulation scheme is 16-QAM. The electronic device 101 may set the transmission power of the RF signal associated with the voice call event based on the first APT table, based on identifying that the first parameter satisfies the first condition.

In an embodiment, the electronic device 101 may perform a voice call connection in operation 611. In an embodiment, by changing magnitude of the baseband signal transferred to the RF circuit based on the second APT table, based on setting the second power as the transmission power of the RF signal associated with the voice call event, the electronic device 101 may perform the voice call connection. In an embodiment, based on setting the first power as the transmission power of the RF signal associated with the voice call event based on the first APT table, the electronic device 101 may perform the voice call connection. In an embodiment, the electronic device 101 may establish an RRC connection with a communication network associated with a voice call service based on a RACH operation.

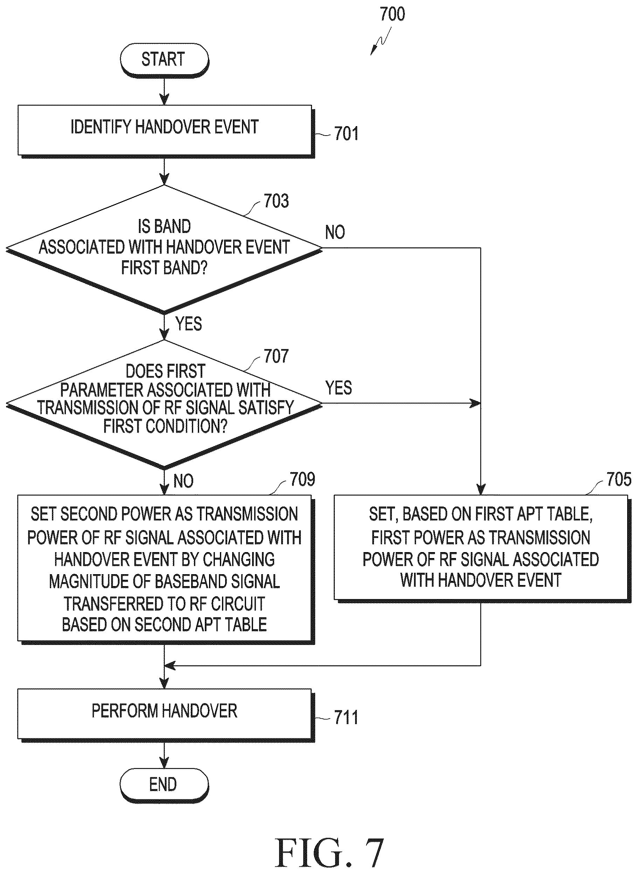

FIG. 7 illustrates a flowchart 700 for describing an operating method of an electronic device according to an embodiment. For an operating method of an electronic device 101, a description overlapping with that of FIG. 4 may not be repeated in FIG. 7.

According to an embodiment, an electronic device 101 (e.g., at least one of a processor 120, a first communication processor 212, a second communication processor 214, an integrated communication processor 260, or a communication processor 310) may identify a handover event in operation 701. In an embodiment, the electronic device 101 may search for a neighbor cell in an RRC idle state. The electronic device 101 may attempt cell reselection based on identifying that strength of a signal received from the neighbor cell is good.

In an embodiment, based on identifying the handover event, the electronic device 101 may identify whether a band associated with the handover event is a first band in operation 703. The electronic device 101 may identify whether a band corresponding to a reselected cell is the first band whose backoff margin is relatively small. The first band may be, for example, a B30 band or a B48 band, and the first band is not limited to an example described above. The electronic device 101 may identify an APT table to be referred to for setting transmission power of an RF signal among a first APT table and a second APT table, based on identifying whether the band associated with the handover event is the first band.

In an embodiment, based on identifying that the band associated with the handover event is not the first band (Operation 703 - No), the electronic device 101 may set first power as the transmission power of the RF signal associated with the handover event based on the first APT table in operation 705. The electronic device 101 may set power according to the first APT table stored in an RF calibration process as the transmission power of the RF signal associated with the handover event, for example, based on identifying that the band associated with the handover event is a second band whose transmission power room is relatively large.

In an embodiment, based on identifying that the band associated with the handover event is the first band (Operation 703 - Yes), the electronic device 101 may identify whether a first parameter associated with transmission of the RF signal satisfies a first condition in operation 707. In an embodiment, the first condition may include that the first parameter matches at least one of a bandwidth, a modulation scheme, or a number of RBs set in association with a network communication which is based on an edge frequency of the first band. For example, the first condition may be a case where a partial RB is allocated in a 10 MHz bandwidth and the modulation scheme is 16-QAM.

In an embodiment, based on identifying that the first parameter associated with the transmission of the RF signal does not satisfy the first condition (Operation 707 - No), the electronic device 101 may set second power as the transmission power of the RF signal associated with the handover event by changing magnitude of a baseband signal transferred to an RF circuit based on the second APT table in operation 709. In an embodiment, based on identifying the first parameter, the electronic device 101 may identify that a full RB is allocated in the 10 MHz bandwidth, and the modulation scheme is QPSK. The electronic device 101 may operate in a TxFE backoff mode based on identifying that the first parameter does not satisfy the first condition. The electronic device 101 may set transmission power of an RF signal corresponding to B30 based on the second APT table additionally stored in an RF calibration process to secure a band-edge performance.

In an embodiment, based on identifying that the first parameter associated with the transmission of the RF signal satisfies the first condition (Operation 707 - Yes), the electronic device 101 may set the first power as the transmission power of the RF signal associated with the handover event, based on the first APT table, in operation 705. In an embodiment, based on identifying the first parameter, the electronic device 101 may identify that the partial RB is allocated in the 10 MHz bandwidth and the modulation scheme is 16-QAM. The electronic device 101 may set the transmission power of the RF signal associated with the handover event based on the first APT table, based on identifying that the first parameter satisfies the first condition.

In an embodiment, the electronic device 101 may perform handover in operation 711. In an embodiment, by changing magnitude of the baseband signal transferred to the RF circuit based on the second APT table, based on setting the second power as the transmission power of the RF signal associated with the handover event, the electronic device 101 may perform the handover. In an embodiment, based on setting the first power as the transmission power of the RF signal associated with the handover event based on the first APT table, the electronic device 101 may perform the handover. In an embodiment, the electronic device 101 may establish an RRC connection with a communication network which manages the neighbor cell based on performing a cell reselection operation.

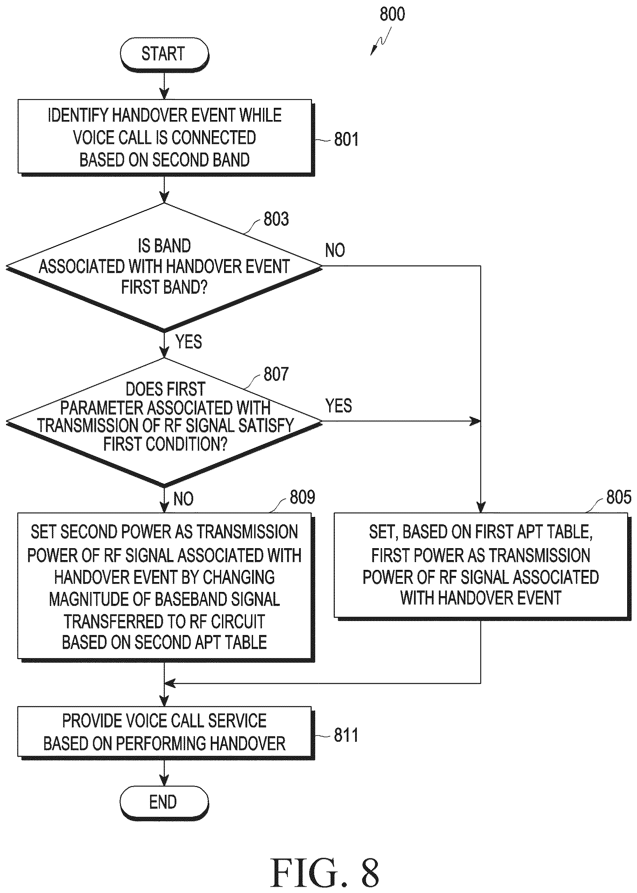

FIG. 8 illustrates a flowchart 800 for describing an operating method of an electronic device according to an embodiment. For an operating method of an electronic device 101, a description overlapping with that of FIG. 4 may not be repeated in FIG. 8.

According to an embodiment, an electronic device 101 (e.g., at least one of a processor 120, a first communication processor 212, a second communication processor 214, an integrated communication processor 260, or a communication processor 310) may identify a handover event while a voice call is connected based on a second band in operation 801. In an embodiment, the electronic device 101 may attempt cell reselection into another cell whose strength of received signal is relatively strong, in an RRC connected state which is based on the second band.

In an embodiment, based on identifying the handover event, the electronic device 101 may identify whether a band associated with the handover event is a first band in operation 803. The electronic device 101 may identify whether a band corresponding to a reselected cell is the first band whose backoff margin is relatively small. The first band may be, for example, a B30 band or a B48 band, and the first band is not limited to an example described above. The electronic device 101 may identify an APT table to be referred to for setting transmission power of an RF signal among a first APT table and a second APT table, based on identifying whether the band associated with the handover event is the first band.

In an embodiment, based on identifying that the band associated with the handover event is not the first band (Operation 803 - No), the electronic device 101 may set first power as the transmission power of the RF signal associated with the handover event based on the first APT table in operation 805. The electronic device 101 may set power according to the first APT table stored in an RF calibration process as the transmission power of the RF signal associated with the handover event, for example, based on identifying that the band associated with the handover event is a second band whose transmission power room is relatively large.

In an embodiment, based on identifying that the band associated with the handover event is the first band (Operation 803 - Yes), the electronic device 101 may identify whether a first parameter associated with transmission of the RF signal satisfies a first condition in operation 807. In an embodiment, the first condition may include that the first parameter matches at least one of a bandwidth, a modulation scheme, or a number of RBs set in association with a network communication which is based on an edge frequency of the first band. For example, the first condition may be a case where a partial RB is allocated in a 10 MHz bandwidth and the modulation scheme is 16-QAM.

In an embodiment, based on identifying that the first parameter associated with the transmission of the RF signal does not satisfy the first condition (Operation 807 - No), the electronic device 101 may set second power as the transmission power of the RF signal associated with the handover event by changing magnitude of a baseband signal transferred to an RF circuit based on the second APT table in operation 809. In an embodiment, based on identifying the first parameter, the electronic device 101 may identify that a full RB is allocated in the 10 MHz bandwidth, and the modulation scheme is QPSK. The electronic device 101 may operate in a TxFE backoff mode based on identifying that the first parameter does not satisfy the first condition. The electronic device 101 may set transmission power of an RF signal corresponding to B30 based on the second APT table additionally stored in an RF calibration process to secure a band-edge performance.

In an embodiment, based on identifying that the first parameter associated with the transmission of the RF signal satisfies the first condition (Operation 807 - Yes), the electronic device 101 may set the first power as the transmission power of the RF signal associated with the handover event, based on the first APT table, in operation 805. In an embodiment, based on identifying the first parameter, the electronic device 101 may identify that the partial RB is allocated in the 10 MHz bandwidth and the modulation scheme is 16-QAM. The electronic device 101 may set the transmission power of the RF signal associated with the handover event based on the first APT table, based on identifying that the first parameter satisfies the first condition.

In an embodiment, the electronic device 101 may perform handover in operation 811. In an embodiment, by changing magnitude of the baseband signal transferred to the RF circuit based on the second APT table, based on setting the second power as the transmission power of the RF signal associated with the handover event, the electronic device 101 may perform the handover. In an embodiment, based on setting the first power as the transmission power of the RF signal associated with the handover event based on the first APT table, the electronic device 101 may perform the handover. In an embodiment, the electronic device 101 may continuously provide a voice call service based on performing the handover.

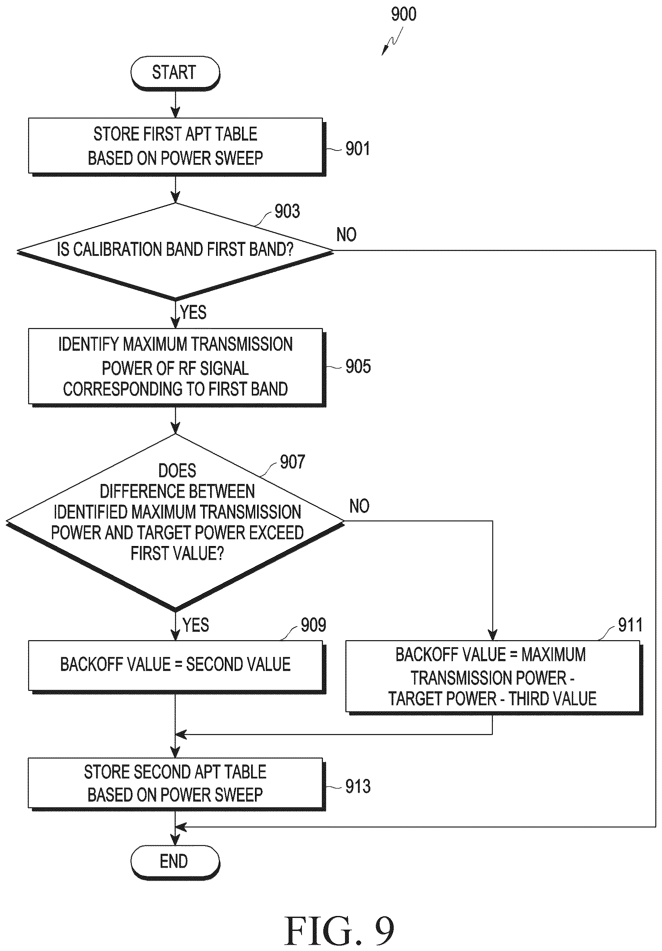

FIG. 9 illustrates a flowchart 900 for describing an operating method of an electronic device according to an embodiment.

According to an embodiment, an electronic device 101 (e.g., at least one of a processor 120, a first communication processor 212, a second communication processor 214, an integrated communication processor 260, or a communication processor 310) may store a first APT table based on a power sweep in operation 901. In an embodiment, the electronic device 101 may generate and store an APT table in an RF calibration process. In an embodiment, the electronic device 101 may generate the first APT table corresponding to each of one or more bands supportable by the electronic device 101. For example, the electronic device 101 may obtain a digital gain and/or an analog gain based on performing a power sweep from a lower limit of transmission power to a upper limit of the transmission power. The electronic device 101 may generate a mapping table based on obtaining a digital gain and/or an analog gain corresponding to each transmission power. In an embodiment, the electronic device 101 may generate the first APT table including a gain value corresponding to transmission power of the RF signal based on the power sweep. The electronic device 101 may store the generated first APT table in memory (for example, memory 130).

In an embodiment, based on storing the first APT table, the electronic device 101 may identify whether a calibration band is a first band in operation 903. The electronic device 101 may identify whether the calibration band is the first band whose backoff margin is relatively small. The first band may be, for example, a B30 band or a B48 band, and the first band is not limited to an example described above. The electronic device 101 may identify whether to additionally store a second APT table based on identifying whether the calibration band is the first band. In an embodiment, the electronic device 101 may not additionally store the second APT table based on identifying the calibration band is not the first band (Operation 903 - No).

In an embodiment, based on identifying that the calibration band is the first band (Operation - Yes), the electronic device 101 may identify maximum transmission power of an RF signal corresponding to the first band in operation 905.

In an embodiment, based on identifying the maximum transmission power of the RF signal corresponding to the first band, the electronic device 101 may identify whether a difference between the identified maximum transmission power and target power exceeds a first value in operation 907. The electronic device 101 may identify, for example, whether the difference between the identified maximum transmission power and the target power is 3 dB or more, and the first value is not limited to an example described above.

In an embodiment, based on identifying that the difference between the identified maximum transmission power and the target power exceeds the first value (Operation 907 - Yes), the electronic device 101 may set a second value as a backoff value in operation 909. In an embodiment, the second value may be the same value for a plurality of electronic devices performing a calibration process. In an embodiment, the second value equal to or greater than the first value may be set as the backoff value of the transmission power.

In an embodiment, based on identifying that the difference between the identified maximum transmission power and the target power is less than or equal to the first value (Operation 907 - No), the electronic device 101 may set a value obtained by subtracting the target power and a third value smaller than the first value from the maximum transmission power as the backoff value of the transmission power in operation 911. In an embodiment, the third value may be 1 dB, and the third value is not limited to an example described above. In an embodiment, the backoff value set in operation 911 may be set differently for each set (or electronic device) in consideration of terminal deviation. The electronic device 101 may perform a TxFE backoff operation in consideration of a deviation between electronic devices based on a backoff value set in an RF calibration process.

In an embodiment, based on setting the backoff value, the electronic device 101 may store the second APT table based on the power sweep in operation 913. In an embodiment, the electronic device 101 may generate the second APT table associated with the first band including a gain value corresponding to the transmission power of the RF signal based on the power sweep. The electronic device 101 may store the second APT table.

According to an embodiment, an electronic device (101) may comprise memory (130) storing instructions, at least one communication processor (120; 212; 214; 260; 310), and at least one RF circuit configured to process an RF signal based on a signal from the at least one communication processor (120; 212; 214; 260; 310). The instructions, when executed by the at least one communication processor (120; 212; 214; 260; 310), may cause the electronic device (101) to, based on identifying a first event, identify whether a band associated with the first event is a first band. The instructions, when executed by the at least one communication processor (120; 212; 214; 260; 310), may cause the electronic device (101) to, based on identifying that the band associated with the first event is the first band, identify whether a first parameter associated with transmission of an RF signal satisfies a first condition. The instructions, when executed by the at least one communication processor (120; 212; 214; 260; 310), may cause the electronic device (101) to, based on identifying that the first parameter satisfies the first condition, set first power as the transmission power of the RF signal associated with the first event based on a first APT table. The instructions, when executed by the at least one communication processor (120; 212; 214; 260; 310), may cause the electronic device (101) to, based on identifying that the first parameter does not satisfy the first condition, set second power as the transmission power of the RF signal associated with the first event by changing magnitude of a baseband signal transmitted to the RF circuit based on a second APT table.

In an embodiment, the first event may include a voice call event. The instructions, when executed by the at least one communication processor (120; 212; 214; 260; 310), may cause the electronic device (101) to, based on setting transmission power of an RF signal associated with a voice call event, perform a voice call connection.

In an embodiment, the first event may include a handover event. The instructions, when executed by the at least one communication processor (120; 212; 214; 260; 310), may cause the electronic device (101) to, based on setting transmission power of an RF signal associated with a handover event, perform handover.

In an embodiment, the instructions, when executed by the at least one communication processor (120; 212; 214; 260; 310), may cause the electronic device (101) to, while a voice call is connected based on a second band, identify a handover event. The instructions, when executed by the at least one communication processor (120; 212; 214; 260; 310), may cause the electronic device (101) to, based on performing the handover, provide a voice call service.

In an embodiment, the first parameter may include at least one of a bandwidth, a modulation scheme, or a number of RBs associated with a network communication corresponding to the first event.

In an embodiment, the first condition may include that the first parameter matches at least one of a bandwidth, a modulation scheme, or a number of RBs set in association with a network communication based on an edge frequency of the first band.

In an embodiment, the instructions, when executed by the at least one communication processor (120; 212; 214; 260; 310), may cause the electronic device (101) to, based on power sweep, generate a second APT table associated with the first band including a gain value corresponding to the transmission power of the RF signal. The instructions, when executed by the at least one communication processor (120; 212; 214; 260; 310), may cause the electronic device (101) to store the second APT table.

In an embodiment, the instructions, when executed by the at least one communication processor (120; 212; 214; 260; 310), may cause the electronic device (101) to, based on identifying that a calibration band is the first band, identify maximum transmission power of an RF signal corresponding to the first band. The instructions, when executed by the at least one communication processor (120; 212; 214; 260; 310), may cause the electronic device (101) to identify whether a difference between the identified maximum transmission power and target power exceeds a first value.

In an embodiment, the instructions, when executed by the at least one communication processor (120; 212; 214; 260; 310), may cause the electronic device (101) to, based on identifying that the difference between the identified maximum transmission power and the target power exceeds the first value, set a second value equal to or greater than the first value as a backoff value of the transmission power. The instructions, when executed by the at least one communication processor (120; 212; 214; 260; 310), may cause the electronic device (101) to, based on identifying that the difference between the identified maximum transmission power and the target power is less than or equal to the first value, set a value obtained by subtracting the target power and a third value less than the first value from the maximum transmission power as the backoff value of the transmission power.

In an embodiment, the instructions, when executed by the at least one communication processor (120; 212; 214; 260; 310), may cause the electronic device (101) to, based on power sweep, generate a first APT table including a gain value corresponding to the transmission power of the RF signal. The instructions, when executed by the at least one communication processor (120; 212; 214; 260; 310), may cause the electronic device (101) to store the first APT table.

In an embodiment, an operating method of an electronic device (101) may comprise, based on identifying a first event, identifying whether a band associated with the first event is a first band. The operating method of the electronic device (101) may comprise, based on identifying that the band associated with the first event is the first band, identifying whether a first parameter associated with transmission of an RF signal satisfies a first condition. The operating method of the electronic device (101) may comprise, based on identifying that the first parameter satisfies the first condition, setting first power as the transmission power of the RF signal associated with the first event based on a first APT table. The operating method of the electronic device (101) may comprise, based on identifying that the first parameter does not satisfy the first condition, setting second power as the transmission power of the RF signal associated with the first event by changing magnitude of a baseband signal transmitted to the RF circuit based on a second APT table.

In an embodiment, the first event may include a voice call event. The operating method of the electronic device (101) may further comprise, based on setting transmission power of an RF signal associated with a voice call event, perform a voice call connection.

In an embodiment, the first event may include a handover event. The operating method of the electronic device (101) may further comprise, based on setting transmission power of an RF signal associated with a handover event, perform handover.

In an embodiment, the operating method of the electronic device (101) may further comprise, while a voice call is connected based on a second band, identifying a handover event. The operating method of the electronic device (101) may further comprise, based on performing the handover, providing a voice call service.

In an embodiment, in the operating method of the electronic device (101), the first parameter may include at least one of a bandwidth, a modulation scheme, or a number of RBs associated with a network communication corresponding to the first event.

In an embodiment, in the operating method of the electronic device (101), the first condition may include that the first parameter matches at least one of a bandwidth, a modulation scheme, or a number of RBs set in association with a network communication based on an edge frequency of the first band.

In an embodiment, the operating method of the electronic device (101) may further comprise, based on power sweep, generating a second APT table associated with the first band including a gain value corresponding to the transmission power of the RF signal. The operating method of the electronic device (101) may further comprise storing the second APT table.

In an embodiment, the operating method of the electronic device (101) may further comprise, based on identifying that a calibration band is the first band, identifying maximum transmission power of an RF signal corresponding to the first band. The operating method of the electronic device (101) may further comprise identifying whether a difference between the identified maximum transmission power and target power exceeds a first value.

In an embodiment, the operating method of the electronic device (101) may further comprise, based on identifying that the difference between the identified maximum transmission power and the target power exceeds the first value, setting a second value equal to or greater than the first value as a backoff value of the transmission power. The operating method of the electronic device (101) may further comprise, based on identifying that the difference between the identified maximum transmission power and the target power is less than or equal to the first value, set a value obtained by subtracting the target power and a third value less than the first value from the maximum transmission power as the backoff value of the transmission power.

In an embodiment, the operating method of the electronic device (101) may further comprise, based on power sweep, generating a first APT table including a gain value corresponding to the transmission power of the RF signal. The operating method of the electronic device (101) may further comprise storing the first APT table.

The electronic device according to an embodiment may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that an embodiment of the disclosure and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with an embodiment of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or two or more functions. For example, according to an embodiment, the module may be implemented in a form of an application-specific integrated circuit (ASIC).

An embodiment as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities, and some of the multiple entities may be separately disposed in different components. According to an embodiment, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
memory (130) storing instructions;
at least one communication processor (120; 212; 214; 260; 310); and
at least one RF circuit configured to process an RF signal based on a signal from the at least one communication processor (120; 212; 214; 260; 310),
wherein the instructions, when executed by the at least one communication processor (120; 212; 214; 260; 310), cause the electronic device (101) to:
based on identifying a first event, identify whether a band associated with the first event is a first band,
based on identifying that the band associated with the first event is the first band, identify whether a first parameter associated with transmission of an RF signal satisfies a first condition,
based on identifying that the first parameter satisfies the first condition, set first power as the transmission power of the RF signal associated with the first event based on a first APT table, and
based on identifying that the first parameter does not satisfy the first condition, set second power as the transmission power of the RF signal associated with the first event by changing magnitude of a baseband signal transmitted to the RF circuit based on a second APT table.

2. The electronic device (101) of claim 1, wherein the first event includes a voice call event, and
wherein the instructions, when executed by the at least one communication processor (120; 212; 214; 260; 310), cause the electronic device (101) to:
based on setting transmission power of an RF signal associated with a voice call event, perform a voice call connection.

3. The electronic device (101) of claim 1 or 2, wherein the first event includes a handover event, and
wherein the instructions, when executed by the at least one communication processor (120; 212; 214; 260; 310), cause the electronic device (101) to:
based on setting transmission power of an RF signal associated with a handover event, perform handover.

4. The electronic device (101) of any one of claims 1 to 3, wherein the instructions, when executed by the at least one communication processor (120; 212; 214; 260; 310), cause the electronic device (101) to:
while a voice call is connected based on a second band, identify a handover event, and
based on performing the handover, provide a voice call service.

5. The electronic device (101) of any one of claims 1 to 4, wherein the first parameter includes at least one of a bandwidth, a modulation scheme, or a number of RBs associated with a network communication corresponding to the first event.

6. The electronic device (101) of any one of claims 1 to 5, wherein the first condition includes that the first parameter matches at least one of a bandwidth, a modulation scheme, or a number of RBs set in association with a network communication based on an edge frequency of the first band.

7. The electronic device (101) of any one of claims 1 to 6, wherein the instructions, when executed by the at least one communication processor (120; 212; 214; 260; 310), cause the electronic device (101) to:
based on power sweep, generate a second APT table associated with the first band including a gain value corresponding to the transmission power of the RF signal, and
store the second APT table.

8. The electronic device (101) of any one of claims 1 to 7, wherein the instructions, when executed by the at least one communication processor (120; 212; 214; 260; 310), cause the electronic device (101) to:
based on identifying that a calibration band is the first band, identify maximum transmission power of an RF signal corresponding to the first band, and
identify whether a difference between the identified maximum transmission power and target power exceeds a first value.

9. The electronic device (101) of any one of claims 1 to 8, wherein the instructions, when executed by the at least one communication processor (120; 212; 214; 260; 310), cause the electronic device (101) to:
based on identifying that the difference between the identified maximum transmission power and the target power exceeds the first value, set a second value equal to or greater than the first value as a backoff value of the transmission power, and
based on identifying that the difference between the identified maximum transmission power and the target power is less than or equal to the first value, set a value obtained by subtracting the target power and a third value less than the first value from the maximum transmission power as the backoff value of the transmission power.

10. The electronic device (101) of any one of claims 1 to 9, wherein the instructions, when executed by the at least one communication processor (120; 212; 214; 260; 310), cause the electronic device (101) to:
based on power sweep, generate a first APT table including a gain value corresponding to the transmission power of the RF signal, and
store the first APT table.

11. An operating method of an electronic device (101), the operating method comprising:
based on identifying a first event, identifying whether a band associated with the first event is a first band;
based on identifying that the band associated with the first event is the first band, identifying whether a first parameter associated with transmission of an RF signal satisfies a first condition;
based on identifying that the first parameter satisfies the first condition, setting first power as the transmission power of the RF signal associated with the first event based on a first APT table; and
based on identifying that the first parameter does not satisfy the first condition, setting second power as the transmission power of the RF signal associated with the first event by changing magnitude of a baseband signal transmitted to the RF circuit based on a second APT table.

12. The operating method of the electronic device (101) of claim 11, wherein the first event includes a voice call event, and
wherein the operating method further comprises:
based on setting transmission power of an RF signal associated with a voice call event, perform a voice call connection.

13. The operating method of the electronic device (101) of claim 11 or 12, wherein the first event includes a handover event, and
wherein the operating method further comprises:
based on setting transmission power of an RF signal associated with a handover event, perform handover.

14. The operating method of the electronic device (101) of any one of claims 11 to 13, further comprising:
while a voice call is connected based on a second band, identifying a handover event; and
based on performing the handover, providing a voice call service.

15. A storage medium storing computer-readable instructions, the instructions, when executed by a communication processor of an electronic device, causing the electronic device to perform at least one operation,
wherein the at least one operation comprises:
based on identifying a first event, identifying whether a band associated with the first event is a first band;
based on identifying that the band associated with the first event is the first band, identifying whether a first parameter associated with transmission of an RF signal satisfies a first condition;
based on identifying that the first parameter satisfies the first condition, setting first power as the transmission power of the RF signal associated with the first event based on a first APT table; and
based on identifying that the first parameter does not satisfy the first condition, setting second power as the transmission power of the RF signal associated with the first event by changing magnitude of a baseband signal transmitted to the RF circuit based on a second APT table.
